# EUROPÄISCHE PATENTANMELDUNG

(11) **EP 1 492 389 A1**
(43) Veröffentlichungstag der Anmeldung: **29.12.2004**
(21) Anmeldenummer: 03405471.8
(22) Anmeldetag: 26.06.2003
(51) Int. Cl.: H05B 33/14, H05B 33/22

(54) **Optische Verstärkermaterialien**

(71) Anmelder: ILFORD Imaging Switzerland GmbH, 1723 Marly 1 (CH)
(72) Erfinder: Beer, Robert, 1723 Marly (CH); Steiger, Rolf, 1724 Praroman-Le Mouret (CH); Schär, Michel, ch-1422 Grandson (CH); Zuppiroli, Libero, 1427 Bonvillars (CH)

(57) **Zusammenfassung**

Es wird ein optisches Verstärkermaterial beschrieben, das auf einem Träger eine darauf aufgebrachte Verstärkerschicht und darüber angeordnet eine Lumineszenzschicht aufweist, dadurch gekennzeichnet, dass die Verstärkerschicht nanokristallines, nanoporöses Aluminiumoxid und/oder Aluminiumoxid/hydroxid sowie gegebenenfalls ein Bindemittel enthält. Die Lumineszenzschicht besteht vorzugsweise aus Tris-(8-hydroxychinolino)-Aluminium.

## Beschreibung

### Technisches Gebiet

Die Erfindung bezieht sich auf ein optisches Verstärkermaterial, das auf einem Träger eine dünne, durchsichtige Verstärkungsschicht, welche nanokristalline, nanoporöse Aluminiumoxide oder Aluminiumoxid/hydroxide und gegebenenfalls ein Bindemittel enthält, sowie darüber angeordnet eine Lumineszenzschicht, vorzugsweise aus Tris-(8-hydroxychinolino)-Aluminium bestehend.

### Stand der Technik

Aerogele können zur Herstellung optischer Verstärkerschichten mit tiefem Brechungsindex verwendet werden, welche die Lichtabstrahlung von lichtemittierenden, lumineszierenden Systemen beträchtlich erhöhen können, wie es beispielsweise von A. Köhler, J. S. Wilson und R. H. Friend in "Fluorescence and Phosphorescence in Organic Materials", Advanced Materials 14, 706 (2002), beschrieben wird. SiO₂-Aerogele sind geeignete Aerogele für solche Verstärkerschichten.

Die Herstellung und die physikalischen Eigenschaften dieser SiO₂-Aerogele werden unter anderem von T. Tsutsui, M. Yahiro, H. Yokogawa, K. Kawano und M. Yokoyama in "Doubling Coupling-Out Efficiency in Organic Light-Emitting Devices Using a Thin Silica Layer", Advanced Materials 13, 1149 (2001) beschrieben. Das Herstellungsverfahren für diese SiO₂-Aerogele ist aber kompliziert und langwierig. Weiter muss, um die Langzeitstabilität dieser SiO₂-Aerogele zu gewährleisten, deren Oberfläche zusätzlich hydrophobisiert werden, wie es beispielsweise in den Patentanmeldungen EP 0'585'456, EP 0'595'456 und EP 1'153'739 der Firma Matsushita Electric Works Ltd. beschrieben wird.

Die Herstellung von SiO₂-Schichten auf Glas, die thermisch zersetzbare Polymere mit einem Brechungsindex zwischen 1.10 und 1.40 enthalten, mit Hilfe des Schleudergusses wird beispielsweise im Patent US 6'204'202 beschrieben.

Solche polymerhaltige Beschichtungen müssen aber während einer Zeit zwischen 10 und 60 Minuten auf eine Temperatur von mindestens 400°C erhitzt werden, damit das Polymer zersetzt wird und reine SiO₂-Schichten mit den gewünschten Verstärkungseigenschaften entstehen. Ohne diese Entfernung der Polymere durch die Hochtemperaturbehandlung verstärken die Schichten die Lichtabstrahlung nicht.

OLED's (Organic light-emitting devices) auf Glas mit einer SiO₂-Unterschicht werden von M.-H.Lu, M. S. Weaver, T. X. Zhou, M. Tothman, R. C. Kwong, M. Hack und J. J. Brown in "High-Efficiency Top-Emitting Organic Light-Emitting Devices", Applied Physics Letters 81, 3921 (2002) beschrieben. Durch das Vorhandensein dieser SiO₂-Unterschicht werden 21% mehr Photonen in einem Kegelwinkel von 120° in die Betrachtungsebene emittiert als ohne diese Unterschicht. Die Herstellung auch der hier beschriebenen SiO₂-Schichten ist kompliziert und erfolgt nach einem ähnlichen Verfahren, wie es von der Firma Matsushita Electric Works Ltd. beschrieben worden ist.

Der Vorteil der Anwendung solcher Schichten für lichtemittierende, lumineszierende Systeme (beispielsweise OLED's) als optische Verstärkermaterialien besteht vor allem darin, dass durch die Erhöhung der emittierten Lichtintensität tiefere Spannungen und Ströme verwendet werden können, was die Lebensdauer solcher emittierender organischer Systeme beträchtlich erhöht, da bekanntlich deren Lebensdauer umgekehrt proportional zum Quadrat der angelegten Spannung ist.

Verbindungen, welche mit hoher Quantenausbeute eine blaue Elektrolumineszenz aufweisen, sind selten, wie der Zusammenstellung von Y. Li, M. K. Fung, Z. Xie, S.-T. Lee, L.-S. Hung und J. Shi in "An Efficient Pure Blue Light-Emitting Device with Low Driving Voltages", Advanced Materials 14, 1317 (2002), entnommen werden kann. Die Herstellung solcher Verbindungen ist aber im allgemeinen kompliziert und nur bei Temperaturen von etwa 400°C möglich.

Die Herstellung einer neuen Verbindung mit blauer Lumineszenz und Elektrolumineszenz aus Tris-(8-hydroxychinolino)-Aluminium bei einer Temperatur von 390° C wurde erstmals von M. Cölle, J. Gmeiner, W. Milius, H. Hillebrecht und W. Brütting in "Preparation and Characterization of Blue-Luminescent Tris(8-hydroxy quinoline) aluminium (Alq₃)", Advanced Functional Materials 13, 108 (2003) beschrieben. Dabei wurden nach mehrstündiger Behandlung des Tris-(8-hydroxychinolino)-Aluminiums bei dieser Temperatur Kristalle einer neuen Kristallstruktur mit blauer Lumineszenz und Elektrolumineszenz erhalten.

Alle bisher bekannten Verfahren zur Herstellung der SiO₂-Verstärkerschichten sind kompliziert und verlangen hohe Temperaturen. Deshalb ist keine kostengünstige Herstellung möglich. Wegen der benötigten hohen Temperaturen können auch keine billigen Trägermaterialien verwendet werden, obwohl die obigen Produkte ihren Zweck in vielen Fällen auch auf vergleichsweise billigen Kunststoffoder Papierträgern erfüllen würden.

Ein weiterer Nachteil der erforderlichen hohen Temperaturen bei der Herstellung ist die Unmöglichkeit, hitzeempfindliche, insbesondere organische Verbindungen wie Sensibilisatorfarbstoffe, Netzmittel und dergleichen, zuzusetzen. Weiter ist es sehr schwierig, dünne, flexible, nichtbrüchige Aerogel-Filme mit guter Haftung auf dem Substrat mit hoher chemischer Stabilität mit dem Sol-Gel-Verfahren herzustellen.

### Zusammenfassung der Erfindung

Wir haben nun Verstärkerschichten für optische Verstärkermaterialien gefunden, bei deren Herstellung keine Hochtemperaturbehandlung nötig ist und die grosstechnisch auf kostengünstigen Trägern hergestellt werden können.

Ziel der Erfindung ist die Bereitstellung von optischen Verstärkermaterialien, welche auf einem kostengünstigen Träger mindestens eine bindemittelarme oder bindemittelfreie, dünne, durchsichtige Verstärkerschicht aus nanokristallinen, nanoporösen Aluminiumoxiden und/oder Aluminiumoxid/hydroxiden mit guter mechanischer Stabilität und darüber angeordnet eine Lumineszenzschicht enthalten, die auch in Anwesenheit des Bindemittels ohne Hochtemperaturbehandlung einen hohen optischen Verstärkungsfaktor aufweisen.

Diese bindemittelarmen oder bindemittelfreien, durchsichtigen Verstärkerschichten aus nanokristallinen, nanoporösen Aluminiumoxiden und/oder Aluminiumoxid/hydroxiden besitzen bei Raumtemperatur zusätzlich eine katalytische Aktivität bei der Umwandlung der grün lumineszierenden Kristallmodifikation des Tris-(8-hydroxychinolino)-Aluminiums (Alq₃) in die blau lumineszierende Kristallmodifikation.

Kostengünstige Träger für die Erfindung sind Glas, beschichtetes oder unbeschichtetes Papier oder Kunststofffolien.

Ein solches Material weist auf dem Träger mindestens eine bindemittelfreie oder bindemittelarme Verstärkungsschicht auf, welche nanokristallines, nanoporöses Alumiumoxid und/oder Aluminiumoxid/hydroxid enthält, und darüber angeordnet eine Lumineszenzschicht, bevorzugt bestehend aus der blau lumineszierenden oder der grün lumineszierenden Kristallmodifikation von Alq₃.

Das Material kann zwischen der Verstärkerschicht und der Lumineszenzschicht gegebenenfalls eine oder mehrere zusätzliche Schichten mit andern Funktionen (beispielsweise erhöhte Leitfähigkeit und niedrigere Oberflächenrauhigkeit durch Indium-Zinn-Oxid oder mechanischer Schutz).

Zur Herstellung der dünnen, durchsichtigen Verstärkerschicht bestehend aus nanokristallinen, nanoporösen Aluminiumoxiden und/oder Aluminiumoxid/hydroxiden sowie gegebenenfalls einem Bindemittel werden wässrige, kolloidale Dispersionen solcher nanokristalliner, nanoporöser Aluminiumoxide und/oder Aluminiumoxid/hydroxide, gegebenenfalls zusammen mit einem Bindemittel, bei Temperaturen zwischen 20° C und 55° C auf Glas, Papier- oder Kunststoffträger, die auch mit Indium-Zinn-Oxid oder Metallen beschichtet sein können, aufgebracht und mit einem Gasgemisch, vorzugsweise Luft, bei Temperaturen unter 100° C, vorzugsweise unter 60° C, getrocknet.

Bevorzugt werden nanokristalline, nanoporöse Aluminiumoxide und Aluminiumoxid/hydroxide oder mit Elementen der seltenen Erden dotierte Aluminiumoxide oder Aluminiumoxid/hydroxide (AIOOH) und γ-Al₂O₃, oder deren Mischungen.

### Ausführliche Beschreibung der Erfindung

Ziel der Erfindung ist die Bereitstellung von optischen Verstärkermaterialien, welche auf einem kostengünstigen Träger mindestens eine bindemittelarme oder bindemittelfreie, dünne, durchsichtige Verstärkerschicht aus nanokristallinen, nanoporösen Aluminiumoxiden und/oder Aluminiumoxid/hydroxiden mit guter mechanischer Stabilität und darüber angeordnet eine Lumineszenzschicht enthalten und die auch in Anwesenheit des Bindemittels ohne Hochtemperaturbehandlung einen hohen optischen Verstärkungsfaktor aufweisen.

Die bindemittelarmen oder bindemittelfreien, durchsichtigen Schichten aus nanokristallinen, nanoporösen Aluminiumoxiden und/oder Aluminiumoxid/hydroxiden besitzen bei Raumtemperatur zusätzlich eine katalytische Aktivität bei der Umwandlung der grün lumineszierenden Kristallmodifikation des Tris-(8-hydroxychinolino)-Aluminiums (Alq₃) in die blau lumineszierende Kristallmodifikation. Damit wird es möglich, aus dem gleichen Vorprodukt je nach Wunsch grün oder blau lumineszierende optische Verstärkermaterialien herzustellen.

An Stelle von Alq₃ können in der Lumineszenzschicht auch andere lichtemittierende, lumineszierende (d. h. fluoreszierende, phosphoreszierende oder elektrolumineszierende) Verbindungen, wie beispielsweise lumineszierende Polymere, verwendet werden. Die Lumineszenzschichten müssen sehr dünn sein, um Lichtleitung innerhalb der lumineszierenden Schicht möglichst zu vermeiden. Die Anregung der Schicht zur Lumineszenz kann mit Hilfe von Licht oder eines elektrischen Feldes (Elektrolumineszenz) erfolgen.

Ein solches Material weist auf einem Träger mindestens eine bindemittelfreie oder bindemittelarme Verstärkerschicht auf, welche nanokristallines, nanoporöses Aluminiumoxid und/oder Aluminiumoxid/hydroxid enthält, sowie, darüber angeordnet, eine Lumineszenzschicht auf. Das Material kann gegebenenfalls zwischen der Verstärkerschicht und der Lumineszenzschicht eine oder mehrere zusätzliche Schichten mit andern Funktionen (beispielsweise erhöhte Leitfähigkeit und niedrigere Oberflächenrauhigkeit durch eine Schicht bestehend aus Indium-Zinn-Oxid oder mechanischer Schutz durch eine dünne Schutzschicht) aufweisen.

In einer besonders bevorzugten Ausführungsart der Erfindung enthält die dünne, durchsichtige Verstärkungsschicht aus Aluminiumoxiden und/oder Aluminiumoxid/hydroxiden kein Bindemittel.

Zur Herstellung der dünnen, durchsichtigen Verstärkungsschicht bestehend aus nanokristallinen, nanoporösen Aluminiumoxiden und/oder Aluminiumoxid/hydroxiden sowie gegebenenfalls einem Bindemittel werden wässrige, kolloidale Dispersionen solcher nanokristalliner, nanoporöser Aluminiumoxide und/oder Aluminiumoxid/ hydroxide, gegebenenfalls zusammen mit dem Bindemittel, bei Temperaturen zwischen 20° C und 55° C auf Glas, Papier- oder Kunststoffträger, die auch mit Indium-Zinn-Oxid oder Metallen beschichtet sein können, aufgebracht und mit einem Gasgemisch, vorzugsweise Luft, bei Temperaturen unter 100° C, vorzugsweise unter 60° C, getrocknet.

In einer bevorzugten Ausführungsart der Erfindung werden wässrige, kolloidale Dispersionen solcher nanokristalliner, nanoporöser Aluminiumoxide und/oder Aluminiumoxid/hydroxide, die kein Bindemittel enthalten, auf Glas, Papier- oder Kunststoffträger aufgebracht und mit einem Gasgemisch, vorzugsweise Luft, bei Temperaturen unter 100° C, vorzugsweise unter 60° C getrocknet.

In einer besonders bevorzugten Ausführungsart der Erfindung werden die wässrigen, kolloidalen Dispersionen solcher nanokristalliner, nanoporöser Aluminiumoxide und/oder Aluminiumoxid/hydroxide bei Temperaturen zwischen 20° C und 55° C, gegebenenfalls zusammen mit einem oder mehreren filmbildenden Bindemitteln, sowie allenfalls weiteren Beschichtungsflüssigkeiten, auf Glas, Papieroder Kunststoffträger aufgebracht und mit einem Gasgemisch, vorzugsweise Luft, bei Temperaturen unter 100° C, vorzugsweise unter 60° C getrocknet. Die Trocknung kann auch durch Infrarotstrahlung oder durch Elektronenstrahlen erfolgen, oder es kann eine kombinierte Trocknung mit einem Gasgemisch unter gleichzeitiger Anwendung von Infrarotstrahlung oder Elektronenstrahlen zum Einsatz kommen.

Ein geeignetes nanokristallines, nanoporöses Aluminiumoxid ist y-Aluminiumoxid, ein geeignetes nanokristallines, nanoporöses Aluminiumoxid/hydroxid der Formel AIOOH ist Pseudoböhmit.

Die Herstellung der nanokristallinen, nanoporösen Aluminiumoxid/hydroxide im Sol-Gel-Verfahren erfolgt mit Vorteil in gänzlicher Abwesenheit von Säure, wie es beispielsweise im Patent DE 3'823'895 beschrieben wird.

In einer besonders bevorzugten Ausführungsart der Erfindung werden die nanokristallinen, nanoporösen Aluminiumoxide oder Aluminiumoxid/hydroxide mit Salzen der seltenen Erden umgesetzt, wie es beispielsweise in der Patentanmeldung EP 0'875'394 beschrieben worden ist. Solche nanokristallinen, nanoporösen Aluminiumoxide oder Aluminiumoxid/hydroxide enthalten eines oder mehrere Elemente der Ordnungszahl 57 bis 71 des Periodischen Systems der Elemente, vorzugsweise in einer Menge zwischen 0.4 und 2.5 Molprozent bezogen auf Al₂O₃. Ein bevorzugtes Element der seltenen Erden ist Lanthan.

Die Grösse dieser nanokristallinen, nanoporösen Aluminiumoxide oder Aluminiumoxid/hydroxide liegt vorzugsweise zwischen 5 nm und 100 nm, besonders bevorzugt zwischen 10 nm und 60 nm. Die nanokristallinen, nanoporösen Aluminiumoxide oder Aluminiumoxid/hydroxide haben bevorzugt eine enge Korngrössenverteilung (± 40 %).

Die nanokristallinen, nanoporösen Aluminiumoxide oder Aluminiumoxid/hydroxide besitzen eine hohe Porosität mit Porenvolumen > 0.2 ml/g.

Die Verstärkerschichten enthalten die nanokristallinen, nanoporösen Aluminiumoxide und/oder Aluminiumoxid/hydroxide in Mengen von 0.2 g/m² bis 20 g/m², vorzugsweise von 1 g/m² bis 10 g/m². Diese Mengen entsprechen Trockenschichtdicken zwischen 0.1 µm und 20 µm, beziehungsweise 1 µm und 10 µm.

Die Menge des filmbildenden Bindemittels, sofern es überhaupt verwendet wird, soll möglichst gering sein, aber noch ausreichend, um stabile, gut auf dem Träger haftende Beschichtungen ohne Brüchigkeit zu erzielen. Mengen bis 20 Gewichtsprozent des filmbildenden Bindemittels können verwendet werden, insbesondere 0.5 % bis 20 % filmbildendes Bindemittel bezogen auf die Gesamtmenge der nanokristallinen, nanoporösen Aluminiumoxide und/oder Aluminiumoxid/hydroxide in der Verstärkerschicht.

Besonders bevorzugt sind werden Mengen bis 5 Gewichtsprozent, insbesondere zwischen 0.5 % und 5 %, bezogen auf die Gesamtmenge der nanokristallinen, nanoporösen Aluminiumoxide und/oder Aluminiumoxid/hydroxide in der Verstärkerschicht.

Geeignete Bindemittel sind, sofern sie verwendet werden, im allgemeinen wasserlösliche, nichtleitende Polymere.

Besonders bevorzugt sind filmbildende, nichtleitende Polymere.

Die wasserlöslichen, nichtleitenden Polymere umfassen beispielsweise natürliche Polymere oder daraus hergestellte modifizierte Verbindungen wie Albumin, Gelatine, Kasein, Stärke, Gummi arabicum, Natrium- oder Kaliumalginat, Hydroxyethylcellulose, Carboxymethylcellulose, α-, β- oder γ-Cyclodextrin usw. Wenn eines der wasserlöslichen Polymere Gelatine ist, so können alle bekannten Gelatinetypen verwendet werden, wie saure Schweinehautgelatine oder alkalische Knochengelatine sowie sauer oder basisch hydrolysierte Gelatinen.

Ein bevorzugtes natürliches, nichtleitendes, filmbildendes Bindemittel ist Gelatine, insbesondere Schweinehautgelatine mit hohem isoelektrischem Punkt.

Synthetische, nichtleitende Bindemittel können ebenfalls verwendet werden, wie beispielsweise Polyvinylalkohol, Polyvinylpyrrolidon, vollständig oder teilweise verseifte Verbindungen von Copolymeren aus Vinylacetat und anderen Monomeren; Homopolymere oder Copolymere von ungesättigten Carbonsäuren wie (Meth)acrylsäure, Maleinsäure, Crotonsäure usw.; Homopolymere oder Copolymere aus Vinylmonomeren von (Meth)acrylamid; Homopolymere oder Copolymere anderer Monomerer mit Ethylenoxid; Polyurethane und Polyacrylamide. Wasserlösliche Nylonpolymere; Polyester; Polyvinyllactame; Acrylamidpolymere; substituierter Polyvinylalkohol; Polyvinylacetale; Polymere aus Alkyl- und Sulfoalkylacrylaten und -methacrylaten; hydrolysierte Polyvinylacetate; Polyamide; Polyvinylpyridine; Polyacrylsäure; Polyacrylnitrile; Copolymere mit Maleinsäureanhydrid; Polyalkylenoxide; Polyethylenglykole; Copolymere mit Methacrylamid und Copolymere mit Maleinsäure oder fluorierte Polymere wie Polyvinylidenfluorid können ebenfalls verwendet werden. Alle diese Polymere können auch als Mischungen verwendet werden.

Bevorzugte synthetische, nichtleitende, filmbildende Bindemittel sind Polyvinylalkohol, Polyvinylidenfluorid, Polyethylenoxide, Polyethylenglykole, Block-Copolymere sowie Polyacrylnitrile oder ihre Mischungen.

Als leitende, filmbildende Polymere können Polythiophene, Polyaniline, Polyacetylene, Poly(3,4-ethylen)dioxythiophen und Polyphenylenvinylene verwendet werden, wobei Poly(3,4-ethylen)dioxythiophen bevorzugt wird. Auch Blockcopolymere aus leitenden und nichtleitenden Polymeren können verwendet werden.

Obwohl wasserunlösliche, leitende oder nichtleitende, filmbildende Bindemittel nicht explizit beansprucht werden, so sollen wasserunlösliche, leitende oder nichtleitende, filmbildende Polymere oder Blockcopolymere trotzdem als Systembestandteil angesehen werden.

Die oben erwähnten Bindemittel mit vernetzbaren Gruppen können mit Hilfe eines Vernetzers oder Härters zu praktisch wasserunlöslichen Schichten umgesetzt werden. Solche Vernetzungen können kovalent oder ionisch sein. Die Vernetzung oder Härtung der Schichten erlaubt eine Veränderung der physikalischen Schichteigenschaften, wie beispielsweise der Flüssigkeitsaufnahme, oder der Widerstandsfähigkeit gegen Schichtverletzungen und Brüchigkeit.

Die Vernetzer und Härter werden auf Grund der zu vernetzenden wasserlöslichen Polymere ausgesucht.

Organische Vernetzer und Härter umfassen z. B. Aldehyde (wie Formaldehyd, Glyoxal oder Glutaraldehyd); N-Methylolverbindungen (wie Dimethylolharnstoff oder Methylol-Dimethylhydantoin); Dioxane (wie 2,3-Dihydroxydioxan); reaktive Vinylverbindungen (wie 1,3,5-Trisacryloyl-Hexahydro-s-Triazin oder Bis-(Vinylsulfonyl)methylether), reaktive Halogenverbindungen (wie 2,4-Dichloro-6-Hydroxy-s-Triazin); Epoxide; Aziridine; Carbamoylpyridinverbindungen oder Mischungen zweier oder mehrerer dieser erwähnten Vernetzer.

Anorganische Vernetzer und Härter umfassen beispielsweise Chromalaun, Aluminiumalaun, Borsäure, Zirkoniumverbindungen oder Titanocene.

Die Schichten können auch reaktive Substanzen enthalten, welche die Schichten unter Einwirkung von UV-Licht, Elektronenstrahlen, Röntgenstrahlen oder Wärme vernetzen.

Materialien, welche auf einem Träger über der Verstärkerschicht bestehend aus nanokristallinen, nanopörosen Aluminiumoxiden und/oder Aluminiumoxid/hydroxiden enthaltenden Schicht eine Schutzschicht zur Verbesserung der mechanischen Stabilität oder eine elektrisch aktive Schicht aufweisen, werden mit Vorteil zusätzlich mit einem Vernetzer gehärtet, welcher an das Bindemittel der Schutzschicht angepasst ist, um eine ausgezeichnete mechanische Festigkeit zu erzielen. Bei Verwendung von Polyvinylalkohol als Bindemittel werden mit Vorteil Borsäure oder Borate als Vernetzer verwendet.

Die Polymere können mit wasserunlöslichen natürlichen oder synthetischen hochmolekularen Verbindungen gemischt werden, insbesondere mit Acryllatices oder Styrolacryllatices.

Als Träger für diese Materialien ist Glas geeignet, aber auch eine grosse Vielfalt an biegsamen Trägern, wie sie unter anderem in der photographischen Industrie eingesetzt werden. Zur Herstellung der hier beschriebenen Materialien können alle Träger, die bei der Herstellung von photographischen Materialien verwendet werden, eingesetzt werden, so beispielsweise transparente Träger aus Celluloseestern wie Cellulosetriacetat, Celluloseacetat, Cellulosepropionat oder Celluloseacetat/butyrat, Polyester wie Polyethylenterephthalat oder Polyethylennaphthalat, Polyamide, Polycarbonate, Polyimide, Polyolefine, Polyvinylacetale, Polyether, Polyvinylchlorid und Polyvinylsulfone. Bevorzugt werden Polyester, insbesondere Polyethylenterephthalat wie beispielsweise Mylar® der Firma DuPont oder Polyethylennaphthalat wegen ihrer ausgezeichneten Dimensionsstabilität.

Bei den in der photographischen Industrie eingesetzten opaken Trägern können beispielsweise Barytpapier, mit Polyolefinen beschichtete Papiere, weissopake Polyester wie beispielsweise Melinex® der Firma DuPont eingesetzt werden. Besonders bevorzugt sind polyolefinbeschichtete Papiere oder weissopaker Polyester. Alle diese Träger können auch mit einer leitenden Metallschicht versehen sein. Mit hoch leitfähigen Schichten ausgerüstete Kunststoffträger oder Glas sind ebenfalls als Träger für erfindungsgemässe Materialien geeignet. Bevorzugt werden in diesem Fall mit Metallen oder mit Indium-Zinn-Oxid beschichtete Kunststoffträger oder mit Indium-Zinn-Oxid beschichtetes Glas.

Es ist vorteilhaft, diese Träger, insbesondere Polyester, vor dem Beguss mit einer Substrierschicht zu versehen, um die Haftung der Schichten auf dem Träger zu verbessern. Solche Substrierschichten sind in der photographischen Industrie wohlbekannt und enthalten z. B. Terpolymere aus Vinylidenchlorid, Acrylnitril und

Acrylsäure oder aus Vinylidenchlorid, Methylacrylat und Itaconsäure. Die Haftung der Schichten auf dem Träger kann auch durch eine Corona-Behandlung des Trägers vor dem Beguss verbessert werden.

Die erfindungsgemässen Verstärkerschichten werden im allgemeinen aus wässrigen Lösungen oder Dispersionen, die alle nötigen Komponenten enthalten, auf den Träger aufgebracht oder vergossen. In vielen Fällen werden Netzmittel als Begusshilfsmittel zugesetzt, um das Giessverhalten und die Schichtgleichmässigkeit zu verbessern. Obwohl solche oberflächenaktiven Verbindungen in der Erfindung nicht beansprucht werden, bilden sie trotzdem einen wesentlichen Bestandteil der Erfindung.

Zur Verhinderung der Brüchigkeit der Verstärkerschicht können Weichmacher wie beispielsweise Glyzerin zugesetzt werden.

Die Giesslösungen können auf verschiedene Arten auf den Träger aufgebracht werden. Die Giessverfahren schliessen beispielsweise bei biegsamen Trägern den Tauchguss, den Extrusionsguss, den Luftmesserguss, den Schlitzguss, den Kaskadenguss und den Vorhangguss ein. Für die Beschichtung von Glas können der Tauchguss oder der Schleuderguss verwendet werden.

Die Giesslösungen können auf Glas und auf biegsame Träger auch mit einem Sprüh- oder einem Druckverfahren wie Tiefdruck oder Offsetdruck aufgebracht werden.

Solche Verstärkerschichten können zusammen mit den oben erwähnten anderen Schichten in mehreren Durchgängen aufgebracht werden. Bevorzugt wird aber das Aufbringen in einem Durchgang.

Die Giessgeschwindigkeit hängt vom verwendeten Verfahren ab und kann innerhalb weiter Grenzen verändert werden. Bevorzugt als Giessverfahren für biegsame Träger wird der Vorhangguss bei Geschwindigkeiten zwischen 30 m/min und 500 m/min.

Ein solcher mit einer Verstärkerschicht bestehend aus nanokristallinem, nanoporösem Aluminiumoxid und/oder Aluminiumoxid/hydroxid und gegebenenfalls einem Bindemittel versehener Träger ist ein geeignetes Substrat, auf das in einem weiteren Verfahrensschritt eine Lumineszenzschicht aufgebracht werden kann, vorzugsweise mit einem thermischen Aufdampfverfahren im Hochvakuum.

Die Lumineszenzschicht besteht vorzugsweise aus Tris-(8-hydroxychinolino)-Aluminium (Alq₃), in einer bevorzugten Ausführungsart der Erfindung aus der grün lumineszierenden Kristallmodifikation von Alq₃.

Durch Belichtung in Anwesenheit von Luft bei Raumtemperatur mit Tageslicht mit einer Lichtmenge von etwa 1000 cd/m² kann diese grün lumineszierende Kristallmodifikation von Alq₃ auf eine äusserst einfache Art in die blau lumineszierende Kristallmodifikation von Alq₃ umgewandelt werden. Diese Umwandlung ist nur dann möglich, wenn die Lumineszenzschicht in direktem Kontakt mit der Verstärkerschicht, die nanokristallines, nanoporöses Aluminiumoxid und/oder Aluminiumoxid/hydroxid enthält, ist.

Auf diese Art ist es möglich, sowohl grün lumineszierende optische Verstärkermaterialien wie auch blau lumineszierende optische Verstärkermaterialien aus dem gleichen Vorprodukt herzustellen. Es ist auch möglich, durch bildmässige Belichtung ein optisches Verstärkermaterial herzustellen, das sowohl grün wie auch blau luminesziert.

Die vorliegende Erfindung wird durch die folgenden Beispiele näher beschrieben, ohne dass sie dadurch in irgendeiner Weise eingeschränkt würde.

### Beispiele

### Beispiel 1

### Verstärkerschicht

20 g Aluminiumoxid/hydroxid der Formel AIOOH, das nach der Vorschrift von Beispiel 1 der Patentanmeldung DE 3'823'895 in Abwesenheit von Säure hergestellt worden war, wurden bei einer Temperatur von 40° C unter guter mechanischer Rührung in 76.5 g einer wässrigen Lösung (1.3%) von Milchsäure dispergiert. Danach wurden 0.16 g einer wässrigen Lösung (50 %) von Glycerin und 3.33 g einer wässrigen Lösung (3%) des Netzmittels Triton® X-100, erhältlich bei Union Carbide Corporation, Danbury, USA, zugegeben. Nach Einstellen des Endgewichtes auf 100 g mit deionisiertem Wasser wurde die Dispersion bei einer Temperatur von 40° C während 3 Minuten mit Ultraschall behandelt. 12 g/m² dieser Giesslösung wurden auf eine hydrophile Glasplatte aufgebracht. Anschliessend wurde die beschichtete Glasplatte während 60 Minuten bei einer Temperatur von 30° C getrocknet.

### Lumineszenzschicht

Auf diese Verstärkerschicht wurde bei Raumtemperatur mit einem thermischen Aufdampfverfahren eine 100 nm dicke Schicht von Alq₃, erhältlich bei H. W. Sands Corporation Jupiter, USA, im Hochvakuum bei einem Druck von weniger als 10⁻⁶ mbar aufgebracht. Die Temperatur im Aufdampfschiffchen wurde durch Widerstandsheizung stufenweise so weit erhöht, bis die Aufdampfrate etwa 0.1 nm pro Sekunde betrug. Nach Abkühlung der ganzen Bedampfungsapparatur auf Raumtemperatur und Erhöhung des Innendruckes auf Normaldruck werden die Proben in lichtdichte, mit Umgebungsluft gefüllte Handschuhboxen gebracht und dort bis zur Prüfung aufbewahrt.

### Vergleichsbeispiel C -1

Im Vergleichsbeispiel C - 1 wurde die Lumineszenzschicht aus Alq₃ von Beispiel 1 direkt auf die Glasplatte aufgedampft.

### Beispiel 2

### Verstärkerschicht

Die Giesslösung der Verstärkerschicht aus Beispiel 1 wurde auf einen durchsichtigen Polyethylenterephthalatträger aufgebracht. Anschliessend wurde der beschichtete Polyethylenterephthalatträger während 60 Minuten bei einer Temperatur von 30° C getrocknet.

### Lumineszenzschicht

Die Lumineszenzschicht wurde wie in Beispiel 1 aufgedampft, aber mit einer Schichtdicke von 300 nm.

### Vergleichsbeispiel C - 2

Im Vergleichsbeispiel C - 2 wurde die Lumineszenzschicht von Beispiel 2 direkt auf den durchsichtigen Polyethylenterephthalatträger aufgedampft.

### Beispiel 3

### Verstärkerschicht

36.7 g einer wässrigen Dispersion (30 %) von Aluminiumoxid der Formel γ-Al₂O₃ (Aerodisp W630, erhältlich bei Degussa AG, Frankfurt am Main, Deutschland) wurden bei einer Temperatur von 40° C unter guter mechanischer Rührung mit 51.51 g deionisiertem Wasser vermischt. Danach wurden 7.33 g einer wässrigen Lösung (6 %) von Polyvinylalkohol (Molekulargewicht 124'000 - 186'000, Hydrolysegrad 99.9 %, erhältlich bei Aldrich, Buchs, Switzerland), 0.16 g einer wässrigen Lösung (50 %) von Glycerin und 3.33 g einer wässrigen Lösung (3 %) des Netzmittels TRITON X100 zugegeben. Nach Einstellen des Endgewichtes auf 100 g mit deionisiertem Wasser wurde die Dispersion bei einer Temperatur von 40° C während 3 Minuten mit Ultraschall behandelt. Die erhaltene Giesslösung mit 22 g Aerodisp W630 pro 100 g Giesslösung zeigte eine hohe Stabilität. Nach Zugabe von 10 g einer wässrigen Lösung (10 %) von Borsäure wurden 12 g/m² dieser Giesslösung auf eine hydrophile Glasplatte aufgebracht. Anschliessend wurde die beschichtete Glasplatte während 60 Minuten bei einer Temperatur von 30° C getrocknet.

### Lumineszenzschicht

Diese Schicht ist die gleiche wie in Beispiel 1.

### Beispiel 4

### Verstärkerschicht

Die Giesslösung der Verstärkerschicht von Beispiel 3 wurde auf einen durchsichtigen Polyethylenterephthalatträger aufgebracht. Anschliessend wurde der beschichtete Polyethylenterephthalatträger während 60 Minuten bei einer Temperatur von 30° C getrocknet.

### Lumineszenzschicht

Diese Schicht ist die gleiche wie in Beispiel 2.

### Prüfung

Der optische Verstärkungsfaktor A wurde durch die Messung der Photolumineszenzintensität in einem Fluoreszenzspektrographen FluoroMax3 der Firma Jobin Yvon Ltd., Stanford, Grossbritannien, beim Emissionsmaximum von 510 nm des Alq₃ bestimmt. Dabei wurden die optischen Verstärkermaterialien der Beispiele und der Vergleichsbeispiele auf einen Objektträger gelegt und unter einem Winkel von 20° mit monochromatischen Licht der Wellenlänge 350 nm bestrahlt. Das Fluoreszenzlicht wurde in einem Winkel von 90° zur Einfallsrichtung des Anregungslichtes gemessen. Der gewählte Einstrahlungswinkel von 20° eliminiert alles Streulicht und auch das Anregungslicht vor Eintritt in den Eingangsspalt des Spektrographen. Als Referenz diente jeweils das Vergleichsmaterial ohne die Verstärkerschicht.

Weitere Muster wurden nach der Herstellung bei Raumtemperatur in Anwesenheit von Luft mit Tageslicht mit einer Lichtmenge von etwa 1000 cd/m² bestrahlt.

### Ergebnisse

Die unter den oben angegeben Versuchsbedingungen erhaltenen Verstärkungsfaktoren der unbestrahlten Muster sind in Tabelle 1 zusammengestellt.

**Tabelle 1**

| Beispiel Nr. | Dicke der aluminiumhaltigen Schicht (nm) | Brechungsindex der aluminiumhaltigen Schicht | Verstärkungsfaktor A |
|---|---|---|---|
| 1 | 2500 | 1.2 | 1.6 |
| C - 1 | - | - | 1.0 |
| 2 | 2400 | 1.3 | 2.2 |
| C - 2 | - | - | 1.0 |
| 3 | 3500 | 1.2 | 2.1 |
| 4 | 3300 | 1.3 | 1.8 |

Der Vergleich der Verstärkungsfaktoren in Tabelle 1 zeigt sofort, dass die Anwesenheit der Verstärkerschicht, die nanokristallines, nanoporöses Aluminiumoxid oder Aluminiumoxid/hydroxid enthält, in den optischen Verstärkermaterialien gemäss unserer Erfindung die Menge des Fluoreszenzlichts wesentlich erhöht. Die erhaltenen Verstärkungsfaktoren sind vergleichbar mit denen von optischen Verstärkermaterialien mit Verstärkerschichten des Standes der Technik aus SiO₂.

Die bei Raumtemperatur mit Tageslicht in Anwesenheit von Luft bestrahlten Muster der optischen Verstärkermaterialien gemäss unserer Erfindung zeigten eine blaue Fluoreszenz von vergleichbarer Intensität wie die grüne Fluoreszenz unbestrahlter Muster.

## Patentansprüche

1. Optische Verstärkermaterialien bestehend aus einem Träger, einer darauf aufgebrachten Verstärkerschicht und einer darüber angeordneten Lumineszenzschicht, **dadurch gekennzeichnet, dass** die Verstärkerschicht nanokristallines, nanoporöses Aluminiumoxid und/oder Aluminiumoxid/hydroxid enthält.

2. Optische Verstärkermaterialien gemäss Anspruch 1, **dadurch gekennzeichnet, dass** die Verstärkerschicht das nanokristalline, nanoporöse Aluminiumoxid und/oder Aluminiumoxid/hydroxid in einer Menge zwischen 0.1 g/m² und 20 g/m² enthält.

3. Optische Verstärkermaterialien gemäss Anspruch 1, **dadurch gekennzeichnet, dass** die Verstärkerschicht das nanokristalline, nanoporöse Aluminiumoxid und/oder Aluminiumoxid/hydroxid in einer Menge zwischen 1 g/m² und 10 g/m² enthält.

4. Optische Verstärkermaterialien gemäss den Ansprüchen 1 bis 3, **dadurch gekennzeichnet, dass** das nanokristalline, nanoporöse Aluminiumoxid und/oder Aluminiumoxid/hydroxid in der Verstärkerschicht eines oder mehrere Elemente der Ordnungszahl 57 bis 71 des Periodischen Systems der Elemente in einer Menge zwischen 0.2 und 2.5 Molprozent bezogen auf Al₂O₃ enthält.

5. Optische Verstärkermaterialien gemäss den Ansprüchen 1 bis 4, **dadurch gekennzeichnet, dass** die Verstärkerschicht ein Bindemittel in einer Menge bis 10 Gewichtsprozent bezogen auf die Menge des nanokristallinen, nanoporösen Aluminiumoxids und/oder Aluminiumoxid/hydroxids enthält.

6. Optische Verstärkermaterialien gemäss den Ansprüchen 1 bis 4, **dadurch gekennzeichnet, dass** die Verstärkerschicht ein Bindemittel in einer Menge bis 5 Gewichtsprozent bezogen auf die Menge des nanokristallinen, nanoporösen Aluminiumoxids und/oder Aluminiumoxid/hydroxids enthält.

7. Optische Verstärkermaterialien gemäss den Ansprüchen 5 und 6, **dadurch gekennzeichnet, dass** das Bindemittel in der Verstärkerschicht filmbildend ist.

8. Optische Verstärkermaterialien gemäss Anspruch 7, **dadurch gekennzeichnet, dass** das Bindemittel in der Verstärkerschicht Polyvinylalkohol ist.

9. Optische Verstärkermaterialien gemäss den Ansprüchen 1 bis 8, **dadurch gekennzeichnet, dass** die Lumineszenzschicht aus Tris-(8-hydroxychinolino)-Aluminium besteht.

10. Optische Verstärkermaterialien gemäss Anspruch 9, **dadurch gekennzeichnet, dass** die Lumineszenzschicht aus Tris-(8-hydroxychinolino)-Aluminium in der grün lumineszierenden Kristallmodifikation besteht.

11. Optische Verstärkermaterialien gemäss Anspruch 10, **dadurch gekennzeichnet, dass** das grün lumineszierende Tris-(8-hydroxychinolino)-Aluminium in der Lumineszenzschicht durch Bestrahlung mit Tageslicht in Anwesenheit von Luft in die blau lumineszierende Kristallform umgewandelt wird.

12. Optische Verstärkermaterialien gemäss den Ansprüchen 1 bis 11, **dadurch gekennzeichnet, dass** als Träger beschichtetes oder unbeschichtetes Papier, Kunststoffträger oder Glas verwendet werden.

13. Mit einer Verstärkerschicht bestehend aus nanokristallinem, nanoporösem Aluminiumoxid und/oder Aluminiumoxid/hydroxid, das gegebenenfalls eines oder mehrere Elemente der Ordnungszahl 57 bis 71 des Periodischen Systems der Elemente in einer Menge zwischen 0.2 und 2.5 Molprozent bezogen auf Al₂O₃ enthält, und gegebenenfalls einem Bindemittel versehener Träger als Substrat, auf das eine Lumineszenzschicht aufgebracht werden kann.
